# EUROPEAN PATENT SPECIFICATION

(11) **EP 2 988 417 B1**
(45) Date of publication and mention of the grant of the patent: **13.05.2020**
(21) Application number: 15181239.3
(22) Date of filing: 17.08.2015
(51) Int. Cl.: H03F 3/72, H03F 3/21, H03F 3/24, H03F 3/191

(54) **POWER AMPLIFIER INTERFACE COMPATIBLE WITH INPUTS SEPARATED BY MODE OR FREQUENCY**
MIT DURCH MODUS ODER FREQUENZ GETRENNTEN EINGABEN KOMPATIBLE LEISTUNGSVERSTÄRKERSCHNITTSTELLE
INTERFACE D'AMPLIFICATEUR DE PUISSANCE COMPATIBLE AVEC DES ENTRÉES SÉPARÉES PAR MODE OU FRÉQUENCE

(30) Priority: 17.08.2014 US 201462038323 P; 17.08.2014 US 201462038322 P
(43) Date of publication of application: 24.02.2016
(73) Proprietor: Skyworks Solutions, Inc., Woburn, MA 01801 (US)
(72) Inventor: PENTICOFF, Joel Anthony, Cedar Rapids, IA Iowa 52411 (US)
(74) Representative: Isarpatent

(56) References cited:
- WO-A1-2013/027538
- US-A1- 2010 277 252
- US-A1- 2010 289 579
- ULRICH BAUERNSCHMITT ET AL: "Concepts for RF Front-Ends for Multi-Mode, Multi-Band Cellular Phones", WIRELESS TECHNOLOGIES, 2007 EUROPEAN CONFERENCE ON, IEEE, PI, 8 October 2007 (2007-10-08), pages 130-133, XP031190924, ISBN: 978-2-87487-003-3
- SANGHYO LEE ET AL: "A single-pole nine-throw antenna switch using radio-frequency microelectromechanical systems technology for broadband multi-mode and multi-band front-ends; A single-pole nine-throw antenna switch", JOURNAL OF MICROMECHANICS & MICROENGINEERING, INSTITUTE OF PHYSICS PUBLISHING, BRISTOL, GB, vol. 18, no. 1, 3 December 2007 (2007-12-03), page 15012, XP020129940, ISSN: 0960-1317
- M.R. Karim ET AL: "W-CDMA and cdma2000 for 3G Mobile Networks", , 1 January 2002 (2002-01-01), XP055551111, US ISBN: 978-0-07-138513-8 Retrieved from the Internet: URL:http://www.microwavejournal.com/Articl e_Images/0002m36.pdf [retrieved on 2019-02-04]

## Description

### BACKGROUND

### Field

The present disclosure generally relates to radio-frequency (RF) power amplifier systems.

### Description of the Related Art

In many radio-frequency (RF) applications, a wireless device can amplify and transmit an RF signal. Such a transmission can be achieved in a given operating mode. Such an RF signal can be in a given frequency band.

Document US 2010/0289579 A1 discloses a switchable amplifier having logic circuitry for selective enabling and disabling a plurality of input transistor pairs within the switchable amplifier. Document US20100277252 A1 discloses a switchable multi-mode RF front end module capable of routing, with a switch circuitry, an RF signal between a 2G and a 3G amplification path.

### SUMMARY

In some implementations, the present disclosure relates to a power amplifier (PA) system having a first block including a first PA configured to operate in a first mode, and a second block separate from the first block including a second PA configured to operate in a second mode. The PA system further includes an interface implemented in the first block. The interface is configured to be capable of routing a radio-frequency (RF) signal from a transceiver to the first PA, and to be capable of routing the RF signal to the second PA.

In some embodiments, the RF signal can be a mode-separated signal. The interface can be configured to route the mode-separated signal to the first PA.

In some embodiments, the RF signal can be a frequency-separated signal. The interface can be configured to route the frequency-separated signal to the second PA. The PA system can further include an electrical connection between the interface of the first block and the second block to facilitate the routing of the frequency-separated signal to the second PA.

In some embodiments, the interface can include a switch having a pole connected to an input port, a first throw and a second throw. The first throw can be connected to the first PA, and the second throw can be connected to an interface port to allow the routing of the RF signal to the second PA.

In some embodiments, the first and second modes can include 2G and 3G modes. In some embodiments, the first block can be configured for the 2G mode, and the second block can be configured for the 3G mode. The PA system can be substantially the same when implemented for mode-separated or frequency-separated operation. In some embodiments, the first block can be configured for the 3G mode, and the second block can be configured for the 2G mode.

In some embodiments, each of the first block and the second block can further include a plurality of amplification paths. The plurality of amplification paths can include a 2G low band (LB) and a 2G high band (HB) for the corresponding block. The plurality of amplification paths can include a 3G low band (LB) and a 3G mid band (MB) for the corresponding block.

According to a number of implementations, the present disclosure relates to a power amplifier (PA) block that includes a PA configured to operate in a first mode, and an interface configured to be capable of routing a radio-frequency (RF) signal from a transceiver to the PA, and also to be capable of routing the RF signal to another PA block configured operate in a second mode.

In some embodiments, the first mode can include a 2G mode or a 3G mode. The second mode can include a 3G mode if the first mode is the 2G mode, and a 2G mode if the first mode is the 3G mode.

In some embodiments, the interface can include a routing circuit. In some embodiments, the routing circuit can include a switch having a pole connected to an input port, a first throw and a second throw. The first throw can be connected to the PA, and the second throw can be connected to an interface port to allow the routing of the RF signal to the other PA block.

In some teachings, the present disclosure relates to a method for amplifying radio-frequency (RF) signals. The method includes receiving a radio-frequency (RF) signal from a transceiver into an interface implemented in a first power amplifier (PA) block configured to operate in a first mode. The method further includes routing the RF signal to a second PA block configured to operate in a second mode.

According to a number of teachings, the present disclosure relates to a method for fabricating a power amplifier (PA) device. The method includes forming a PA circuit on a substrate, with the PA circuit being configured to operate in a first mode. The method further includes forming a routing circuit on the substrate, with the routing circuit being configured to be capable of receiving a radio-frequency (RF) signal, and to be capable of routing the RF signal to the PA circuit or another PA circuit configured operate in a second mode.

In accordance with a number of implementations, the present disclosure relates to a method for implementing a power amplifier (PA) system on a circuit board. The method includes mounting a first block on the circuit board, where the first block includes a first PA configured to operate in a first mode, and an interface. The method further includes mounting a second block on the circuit board, where the second block includes a second PA configured to operate in a second mode. The method further includes forming a plurality of electrical connections for the interface to allow the first and second PAs to amplify mode-separated radio-frequency (RF) signals or frequency-separated RF signals.

In some implementations, the present disclosure relates to a wireless device that includes a transceiver configured to generate a radio-frequency (RF) signal, and a power amplifier (PA) system in communication with the transceiver. The PA system is configured to amplify the RF signal, and includes a first block having a first PA configured to operate in a first mode, and a second block having a second PA configured to operate in a second mode. The PA system further includes an interface implemented in the first block. The interface is configured to be capable of routing the RF signal to the first PA, and to be capable of routing the RF signal to the second PA. The wireless device further includes an antenna in communication with the PA system and configured to facilitate transmission of the amplified RF signal. In some embodiments, the wireless device can be a cellular phone capable of operating in 2G and 3G modes.

### BRIEF DESCRIPTION OF THE DRAWINGS

Figure 1 depicts a power amplifier (PA) system having an interface.
Figure 2 shows an example of an interface that can be implemented for a PA system having a first PA block and a second PA block.
Figure 3 shows a PA system having first and second PA blocks implemented such that sources of RF signals are separated by mode.
Figure 4 shows a PA system having first and second PA blocks implemented such that sources of RF signals are separated by frequency.
Figure 5 shows an example of a conventional PA system configured to process 2G and 3G signals separated by mode.
Figure 6 shows an example of a conventional PA system configured to process 2G and 3G signals separated by frequency.
Figure 7 shows an example PA system that can be configured to receive RF signals that are separated by mode at a transceiver, and including a 2G PA block and a 3G PA block.
Figure 8 shows an example PA system that can be configured to receive RF signals that are separated by frequency at a transceiver, and including a 2G PA block and a 3G PA block.
Figure 9 shows another example PA system that can be configured to receive RF signals that are separated by mode at a transceiver, and including a 2G PA block and a 3G PA block.
Figure 10 shows another example PA system that can be configured to receive RF signals that are separated by frequency at a transceiver, and including a 2G PA block and a 3G PA block.
Figure 11 shows an example PA system that can be configured to accommodate two separate 2G transceivers.
Figure 12 shows that in some embodiments, one or more features of the present disclosure can be utilized to facilitate processing of 2G signals through a plurality of 3G/4G amplification paths.
Figure 13 shows a process that can be implemented to operate a PA system.
Figure 14 shows a process that can be implemented to fabricate a device having a PA system.
Figure 15 shows a process that can be utilized to implement a chipset in a wireless device such as a cellular phone.
Figure 16 depicts an example wireless device having one or more advantageous features described herein.

### DETAILED DESCRIPTION OF SOME EMBODIMENTS

The headings provided herein, if any, are for convenience only and do not necessarily affect the scope or meaning of the claimed invention.

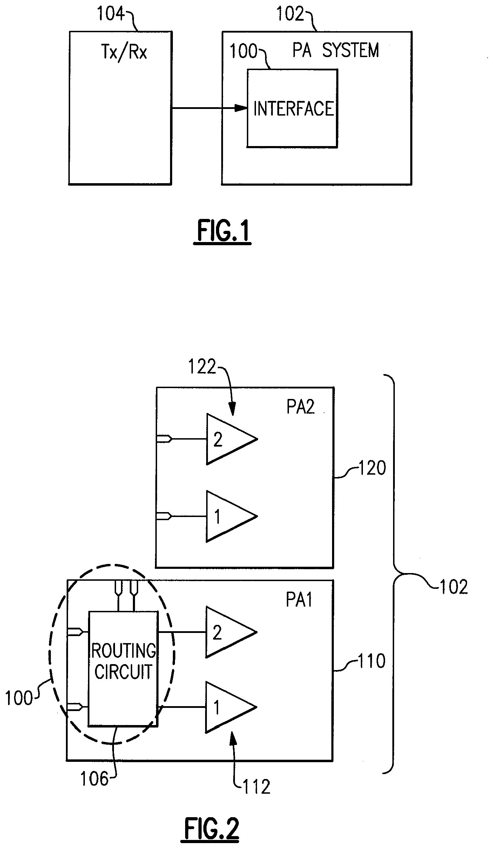

Figure 1 depicts a power amplifier (PA) system 102 having an interface 100. As described herein, such an interface can be configured to provide advantageous functionalities in how the PA system 102 receives and processes radio-frequency (RF) signals from a transceiver 104.

Figure 2 shows an example of an interface 100 that can be implemented for a PA system 102 having a first PA block 110 and a second PA block 120. In some embodiments, the PA blocks 110, 120 can be implemented as, for example, PA die, PA modules, parts of other die or modules, chips, or any combination thereof. In some embodiments, the PA blocks can also be implemented as generally separate blocks on a common die, module, etc. Although various examples are described herein in the context of two PA blocks, it will be understood that one or more features of the present disclosure can also be utilized for PA systems having different numbers of PA blocks.

In the example of Figure 2, each of the first and second PA blocks 110, 120 is shown to include a plurality of PAs 112, 122. For the purpose of description, such PAs are indicated as "1" and "2" in each PA block; however, it will be understood that amplification path "1" of the first PA block 110 typically differs in mode and/or frequency from amplification path "1" of the second PA block 120. In some situations, there may be overlap or similarity in frequency ranges of among such amplification paths the first and second PA blocks 110, 120. Similar features can apply to amplification paths "2" of the first and second PA blocks 110, 120. Further, although various examples are described herein in the context of two amplification paths per PA block, it will be understood that one or more features of the present disclosure can also be utilized for PA blocks having different numbers of amplification paths.

Figure 2 shows that in some embodiments, the interface 100 can be a routing circuit 106 implemented in the first PA block 110. Various examples of such a routing circuit are described herein in greater detail. As described herein, such a routing circuit can allow the first and second PA blocks 110, 120 to be interfaced separately with a transceiver (not shown), together, or any combination thereof. In some applications, such a feature can provide significant flexibility in chipset designs using substantially same PA blocks.

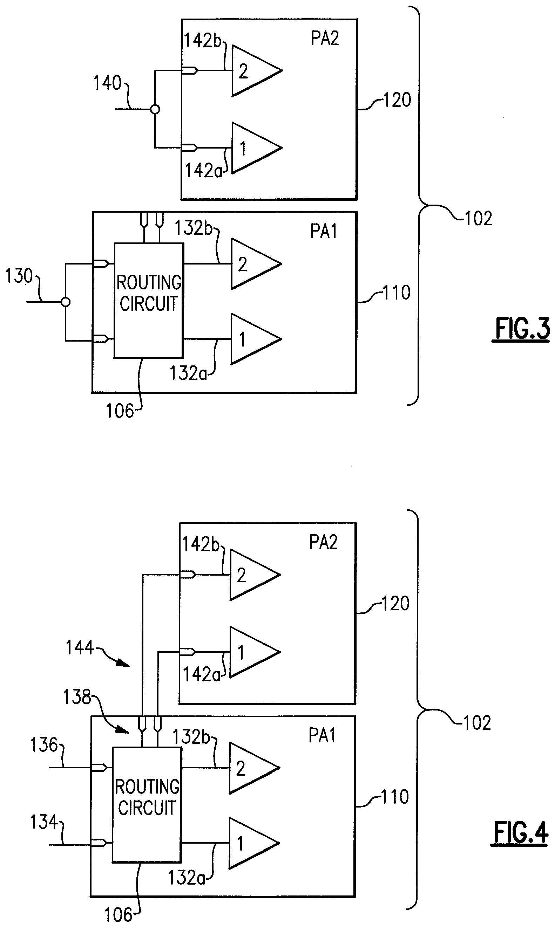

Figures 3 and 4 show an example of such design flexibility utilizing the same PA blocks 110, 120. In Figure 3, a PA system 102 having the first and second PA blocks 110, 120 is implemented such that sources of RF signals are separated by mode (e.g., at a transceiver). Accordingly, the first PA block 110 can receive one or more first mode signals through an input 130. Similarly, the second PA block 120 can receive one or more second mode signals through an input 140. Examples of such first and second modes are described herein in greater detail.

In the example of Figure 3, a routing circuit 106 of the first PA block 110 can be configured such that the one or more first mode signals received through the input 130 is/are routed to its/their respective PA(s). For example, a first RF signal (first mode) to be amplified can be routed to the first PA through path 132a. Similarly, a second RF signal (first mode) to be amplified can be routed to the second PA through path 132b.

Referring to Figure 3, the one or more second mode signals received through the input 140 is/are routed to its/their respective PA(s). For example, a first RF signal (second mode) to be amplified can be routed to the first PA through path 142a. Similarly, a second RF signal (second mode) to be amplified can be routed to the second PA through path 142b. Accordingly, one can see that the inputs of the first and second PA blocks 110, 120 remain generally separated in the example of Figure 3.

In Figure 4, a PA system 102 having the first and second PA blocks 110, 120 is implemented such that sources of RF signals are separated by frequency. Accordingly, the first PA block 110 can receive a plurality of frequency-separated RF signals from a transceiver (not shown). For the purpose of description herein, such frequency separation and related frequencies can be based on frequency values, frequency ranges (e.g., as in frequency bands), or any combination thereof.

In the example of Figure 4, a first RF signal having a first frequency is shown to be received by the routing circuit 106 through a first input 134. Similarly, a second RF signal having a second frequency is shown to be received by the routing circuit 106 through a second input 136. Examples of such first and second frequencies are described herein in greater detail.

If the PA system 102 of Figure 4 is to be operated with the first PA block 110, the routing circuit 106 can be configured such that the RF signal(s) received through the input(s) (134 or/and 136) is/are routed to its/their respective PA(s) in the first PA block 110. For example, the first RF signal (first frequency) to be amplified can be routed to the first PA through path 132a. Similarly, the second RF signal (second frequency) to be amplified can be routed to the second PA through path 132b.

If the PA system 102 of Figure 4 is to be operated with the second PA block 120, the routing circuit 106 can be configured such that the RF signal(s) received through the input(s) (134 or/and 136) is/are routed to its/their respective PA(s) in the second PA block 120. Such routing of RF signals between the two PA blocks is shown to be facilitated by signal paths 138 implemented in the first PA block 110, and signal paths 144 implemented between the first and second PA blocks 110, 120. Accordingly, the first RF signal (first frequency) to be amplified can be routed to the first PA of the second PA block 120 through one of the signal paths 138, one of the signal paths 144, and path 142a. Similarly, the second RF signal (second frequency) to be amplified can be routed to the second PA of the second PA block 120 through one of the signal paths 138, one of the signal paths 144, and path 142b.

Based on the foregoing example described in reference to Figures 3 and 4, one can see that substantially the same PA blocks 110, 120 can be utilized for both of the band-separated (Figure 3) and frequency-separated (Figure 4) configurations. As described herein, such an advantageous flexibility can be facilitated by one or more features of the routing circuit 106.

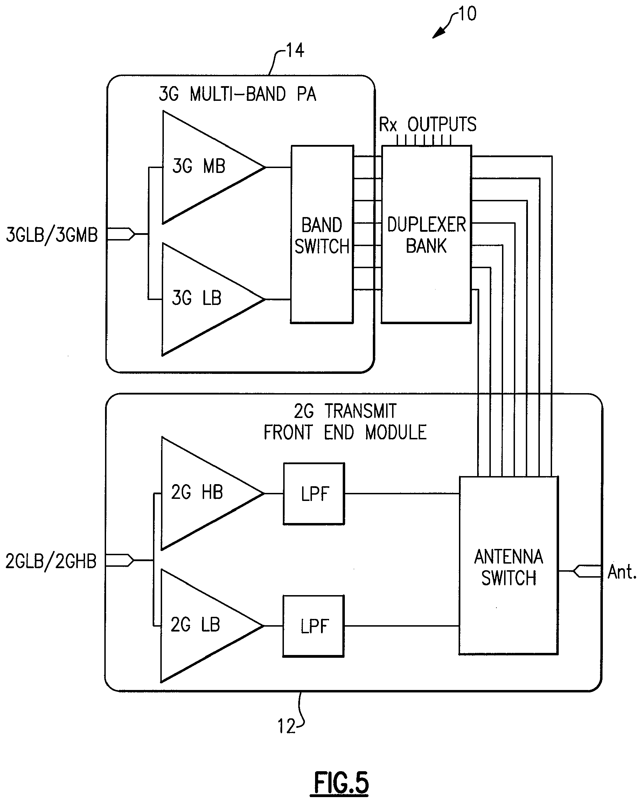

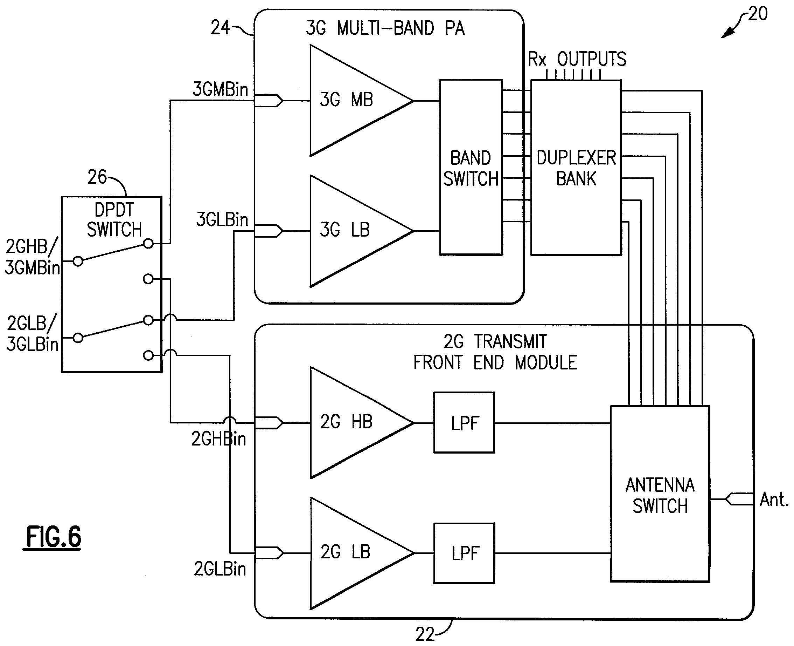

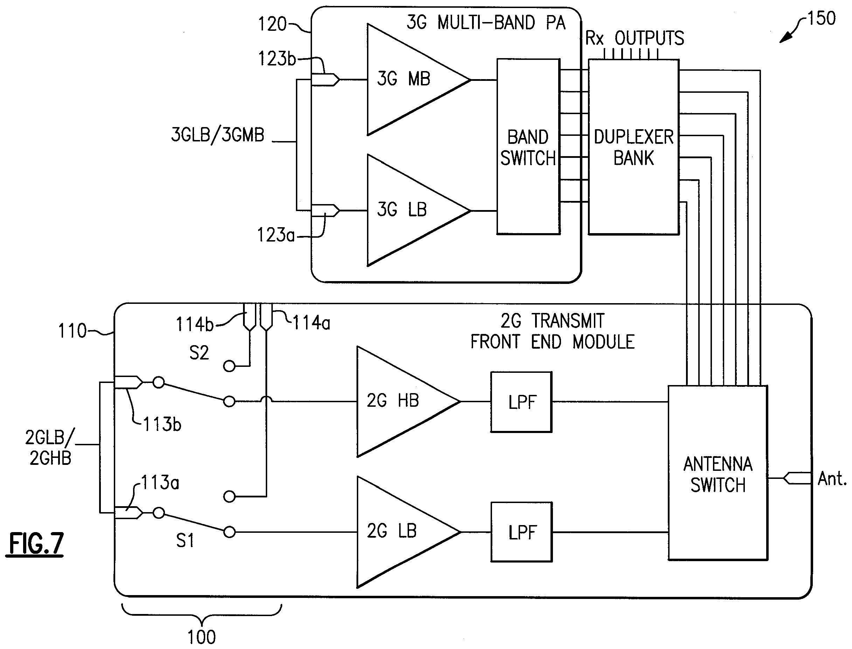

In some RF applications, the foregoing advantageous features provided by the routing circuit implemented on a PA block (e.g., the first PA block 110 of Figures 3 and 4) can be useful in PA systems involving 2G and 3G modes. In the context of 2G and 3G applications, Figures 5 and 6 show examples of conventional PA systems for comparison with various examples of PA systems of Figures 7-12, where routing functionalities as described herein can be implemented in at least one PA block.

Although various examples are described in the context of 2G and 3G applications, it will be understood that one or more features of the present disclosure can also be implemented in other combinations of modes used in the past, currently in use, to be used in the future, or any combination thereof. It will also be understood that one or more features implemented for 3G bands can also be implemented for 4G bands.

Figure 5 shows an example of a conventional PA system 10 configured to process 2G and 3G signals from a transceiver (not shown). Such signals are separated by mode (e.g., 2G and 3G) from the transceiver. Accordingly, one or more 2G signals can be provided directly to a 2G PA block 12, and one or more 3G signals can be provided directly to a 3G PA block 14. For example, the 2G PA block 12 is shown to include dual-band PAs (2G low band (LB), 2G high band (HB)) receiving their respective signals (2GLB/2GHB) through a single input. Similarly, the 3G PA block 14 is shown to include dual-band PAs (3G LB), 3G mid band (MB)) receiving their respective signals (3GLB/3GMB) through a single input.

Figure 6 shows an example of a conventional PA system 20 configured to process 2G and 3G signals from a transceiver (not shown). Such signals are separated by frequency (e.g., 2GLB/3GLB and 2GHB/3GMB) from the transceiver. To route such input signals to appropriate PAs in 2G PA block 22 and 3G PA block 24, a switching circuit 26 is typically provided, where the switching circuit 26 is external to both of the 2G PA and 3G PA blocks 22, 24.

The switching circuit 26 is depicted as having a pole for each of the two inputs, and two throws for each pole. More particularly, the first pole is shown to receive a 2GLB signal or a 3GLB signal from the transceiver, and the second pole is shown to receive a 2GHB signal or a 3GMB signal from the transceiver. When operating in 2G mode, the first pole can be connected to the first throw to thereby route the 2GLB signal to a 2G LB PA in the 2G PA block 22, and second pole can be connected to the first throw to thereby route the 2GHB signal to a 2G HB PA also in the 2G PA block 22. Similarly, when operating in 3G mode, the first pole can be connected to the second throw to thereby route the 3GLB signal to a 3G LB PA in the 3G PA block 24, and second pole can be connected to the second throw to thereby route the 3GMB signal to a 3G MB PA also in the 3G PA block 24.

In the foregoing examples described in reference to Figures 5 and 6, one can see that the input configurations for the PA blocks are significantly different between the mode-separated configuration and the frequency-separated configuration. For example, in each of the 2G PA block 12 and 3G PA block 14 of Figure 5, a single input is shown to split into two input paths within the corresponding PA block. In contrast, in each of the 2G PA block 22 and 3G PA block 24 of Figure 6, two separate input paths are shown to be provided for the two PAs. Accordingly, the 2G PA block 12 of Figure 5 and the 2G PA block 22 of Figure 6 generally cannot be interchanged. Similarly, the 3G PA block 14 of Figure 5 and the 3G PA block 24 of Figure 6 generally also cannot be interchanged.

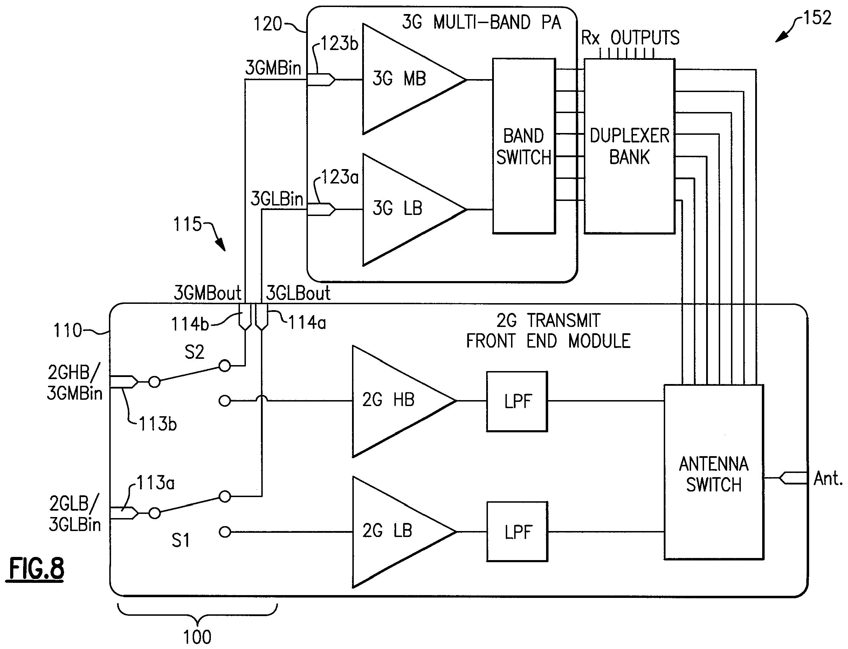

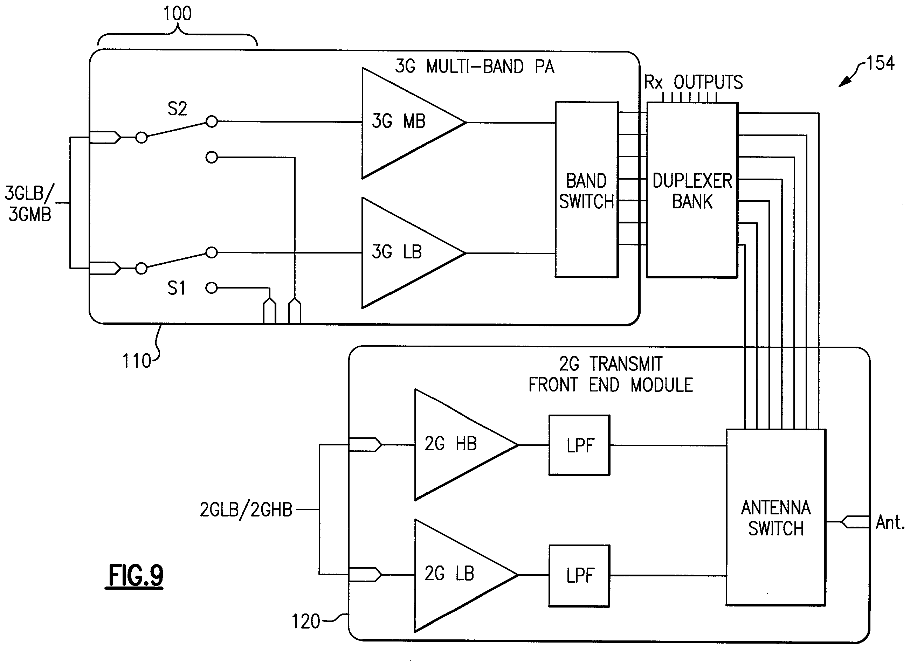

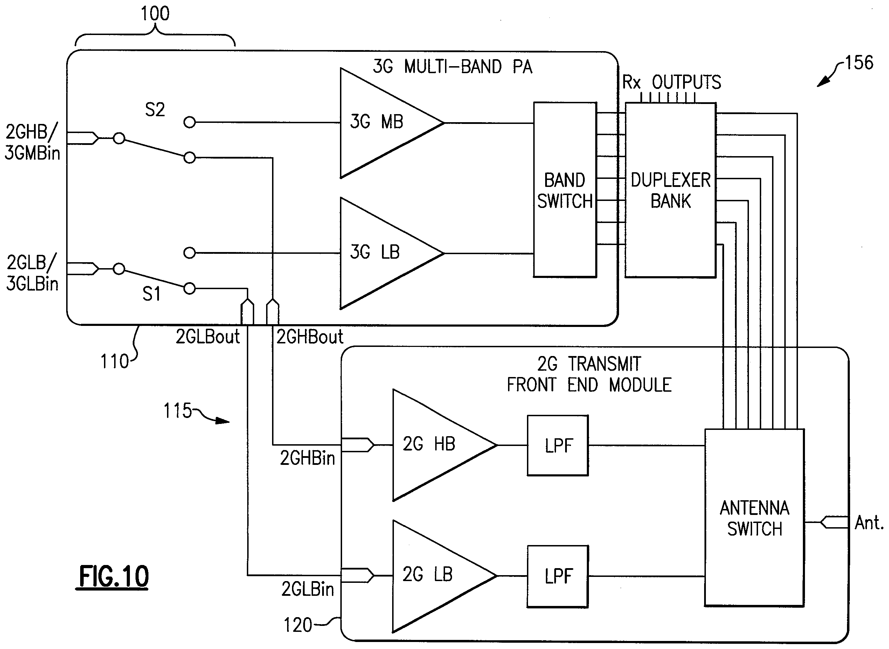

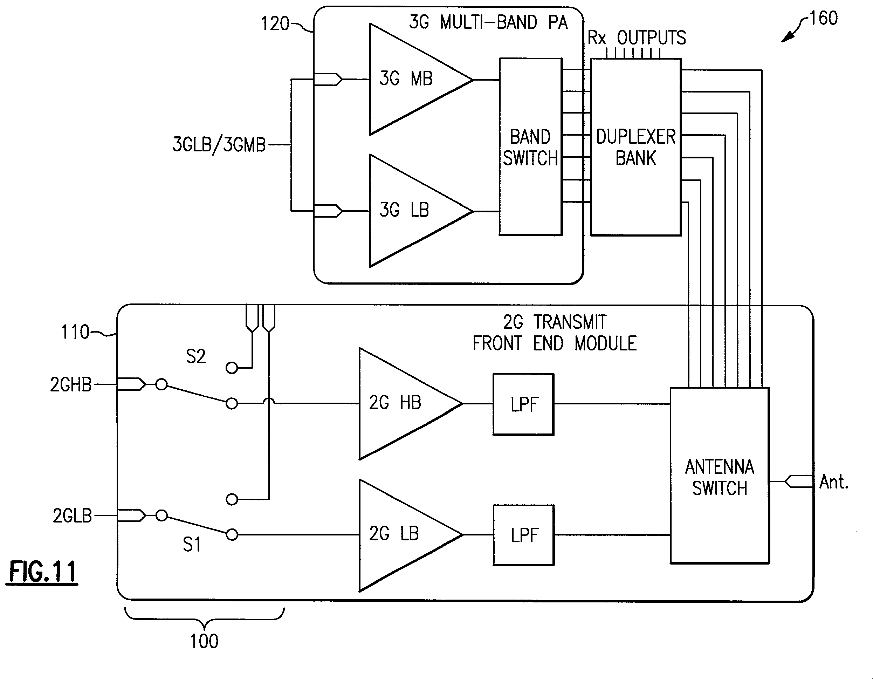

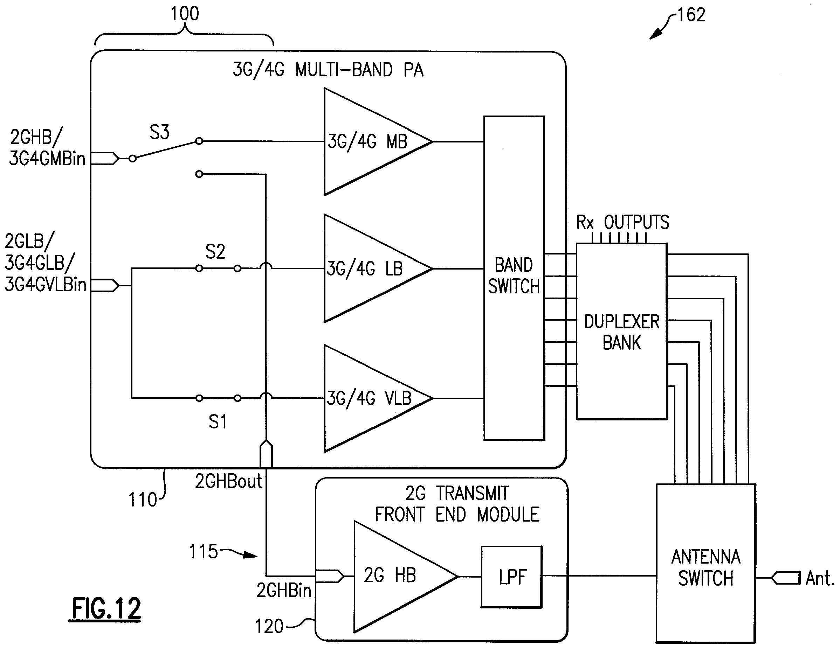

Figures 7-12 show non-limiting examples of a PA system where a routing circuit 100 can be implemented in at least one PA block. Figures 7 and 8 show examples of mode-separated and frequency-separated source configurations, respectively, where a 2G PA block includes such a routing circuit. Figures 9 and 10 show examples of mode-separated and frequency-separated source configurations, respectively, where a 3G PA block includes such a routing circuit. Figures 11 and 12 show additional examples where one of the 2G PA and 3G PA blocks includes such a routing circuit.

In Figure 7, a PA system 150 is shown to be configured to receive RF signals that are separated by mode at a transceiver (not shown). The PA system 150 is shown to include a 2G PA block 110 and a 3G PA block 120. The 2G PA block 110 is shown to include a routing circuit 100 configured to receive 2GLB/2GHB signals from a single source. More particularly, the routing circuit 100 can include two input ports (113a, 113b) and two corresponding switches (S1, S2), with each input port being connected to a pole of the corresponding switch. For example, the first input port 113a can be connected to the pole of the first switch S1, and the second input port 113b can be connected to the pole of the second switch S2.

In the example of Figure 7, each of the switches S1, S2 is shown to include two throws. For the first switch S1, the first throw is shown to be connected to an input of a 2G LB PA. Similarly, the first throw of the second switch S2 is shown to be connected to an input of a 2G HB PA.

The second throw of each of the first and second switches S1, S2 is shown to be connected to an interface port (114a or 114b) that is unused in the example configuration of Figure 7. When implemented in a frequency-separated configuration (e.g., Figure 8), such interface ports can provide desired connectivity between the 2G PA and 3G PA blocks.

Referring to Figure 7, the 3G PA block 120 is shown to include two input ports 123a, 123b that are connected to 3G LB PA and 3G MB PA, respectively. Accordingly, the 3GLB/3GMB signals from the single frequency-separated source is shown to be split into the two input ports 123a, 123b of the 3G PA block 120. Thus, the 3G PA block 120 can process 3G signals generally independently from the 2G PA block 110.

Similarly, the 2GLB/2GHB signals from the single frequency-separated source is shown to be split into the two input ports 113a, 113b of the 2G PA block 110. Accordingly, with the two switches S1, S2 having the poles connected to the first throws (as shown in Figure 7), the 2G PA block can process 2G signals generally independently from the 3G PA block 120.

In Figure 8, a PA system 152 is shown to be configured to receive RF signals that are separated by frequency at a transceiver (not shown). The PA system 152 is shown to include a 2G PA block 110 and a 3G PA block 120. In some embodiments, the 2G PA and 3G PA blocks 110, 120 of Figure 8 can be substantially same as the 2G PA and 3G PA blocks 110, 120 of Figure 7. As described herein, input configurations can be adjusted from the examples of Figure 7 to accommodate the frequency-separated system of Figure 8.

In Figure 8, 2GLB/3GLB signals from a frequency-separated source are shown to be provided to the first input port 113a. With the first switch S1 having its pole connected to the second throw as shown in Figure 8, the 2GLB/3GLB signals can be routed to the 3G LB PA of the 3G PA block 120 for amplification, through the first interface port 114a of the 2G PA block 110, one of inter-block connections 115, and the first input port 123a of the 3G PA block 120.

Similarly, 2GHB/3GMB signals from the frequency-separated source are shown to be provided to the second input port 113b. With the second switch S2 having its pole connected to the second throw as shown in Figure 8, the 2GHB/3GMB signals can be routed to the 3G MB PA of the 3G PA block 120 for amplification, through the second interface port 114b of the 2G PA block 110, one of the inter-block connections 115, and the second input port 123b of the 3G PA block 120.

In the example of Figure 8, all of the input signals are shown to be routed to the 3G PA block 120 for amplification. However, it will be understood that some or all of such input signals can also be amplified by the 2G PA block 110.

Figures 9 and 10 show examples of mode-separated and frequency-separated source configurations, respectively, where a 3G PA block includes such a routing circuit. In Figure 9, a PA system 154 is shown to be configured to receive RF signals that are separated by mode at a transceiver (not shown). The PA system 154 is shown to include a 2G PA block 110 and a 3G PA block 120. The 3G PA block 120 is shown to include a routing circuit 100. Other than the routing circuit 100 being implemented in the 3G PA block 120 instead of the 2G PA block 110, the PA system 154 of Figure 9 can be similar to the example of Figure 7.

Accordingly, 2GLB/2GHB signals from a single frequency-separated source are shown to be split into the two input ports of the 2G PA block 110. Thus, the 2G PA block 110 can process 2G signals generally independently from the 3G PA block 120. Similarly, 3GLB/3GMB signals from the single frequency-separated source are shown to be split into the two input ports of the 3G PA block 120. Accordingly, with the two switches S1, S2 having the poles connected to the first throws (as shown in Figure 9), the 3G PA block can process 3G signals generally independently from the 2G PA block 110.

In Figure 10, a PA system 156 is shown to be configured to receive RF signals that are separated by frequency at a transceiver (not shown). The PA system 156 is shown to include a 2G PA block 110 and a 3G PA block 120. The 3G PA block 120 is shown to include a routing circuit 100. Other than the routing circuit 100 being implemented in the 3G PA block 120 instead of the 2G PA block 110, the PA system 156 of Figure 10 can be similar to the example of Figure 8.

Accordingly, 2GLB/3GLB signals from a frequency-separated source are shown to be provided to the first input port of the 3G PA block 120, and can be routed to the 2G LB PA of the 2G PA block 110 as described herein. Similarly, 2GHB/3GMB signals from the frequency-separated source are shown to be provided to the second input port of the 3G PA block 120, and can be routed to the 2G HB PA of the 2G PA block 110. In the example of Figure 10, all of the input signals are shown to be routed to the 2G PA block 110 for amplification. However, it will be understood that some or all of such input signals can also be amplified by the 3G PA block 120.

In the example conventional PA systems of Figures 5 and 6, as well as the example PA systems of Figures 7-12, the output of the 2G LB PA (in the 2G PA blocks) is shown to be routed to an antenna switch through a low-pass filter. Similarly, the output of the 2G HB PA is shown to be routed to the antenna switch through a low-pass filter. For the 3G signals, the amplified signals are show to be routed from the outputs of the 3G LB and 3G MB PAs to the antenna switch through a band selection switch and a duplexer bank. The antenna switch is shown to be connected to an antenna port to facilitate transmission of the amplified 2G/3G signals.

In some embodiments, the same antenna port and the antenna switch can also facilitate receive (RX) operations. In such a case, the received signals can be routed from the antenna port to "Rx Outputs" through the antenna switch and the duplexer bank.

In the various example PA systems of Figures 7-12, the 2G PA block 110 is depicted as a front-end module (FEM). However, it will be understood that 2G PA blocks having one or more features as described herein can also be implemented as other types of devices.

In some embodiments, the 3G PA block 120 having one or more features as described herein can be implemented in, for example, a die (e.g., a PA die) or a packaged module (e.g., a PA module or a front-end module). In some embodiments, the 2G PA block 110 and 3G PA block 120 having one or more features as described herein do not necessarily need to be implemented in separate devices, and some or all of such PA blocks can be implemented in a common device.

In the various examples described herein in reference to Figures 7-12, one can see that the same PA blocks can be used for both mode-separated and frequency-separated applications. More particularly, minor changes in connections to the input ports and connections between the PA blocks allows the same PA blocks to be utilized for both of the mode-separated and frequency-separated applications. Further, the need for an external switch (in the conventional PA system for frequency-separated operation (e.g., Figure 6)) can be eliminated.

Figures 11 and 12 show examples of variations that can be implemented from the various configurations described in reference to Figures 7-10. It will be understood that other design variations are also possible.

In Figure 11, a PA system 160 can be configured to, for example, accommodate situations involving two separate 2G transceivers. For example, one transceiver can provide a low band signal 2GLB, and another transceiver can provide a high band signal 2GHB to the PA system 160. In such a situation, the 2GLB and 2GHB signals can be provided to the first and second input ports of a 2G PA block 110 similar to the example of Figure 7. Accordingly, either or both of the 2GLB and 2GHB signals can be amplified by the corresponding PAs in the 2G PA block 110 as described herein.

Figure 12 shows that in some embodiments, one or more features of the present disclosure can be utilized to facilitate, for example, processing 2G signals through a plurality of 3G/4G amplification paths. In a PA system 162 of Figure 12, a low band 2G signal (2GLB) is shown to be provided to a 3G/4G low band PA and a 3G/4G very low band PA. Additional details concerning such a technique are described in U.S. Provisional Application No. 62/038,322 filed August 17, 2014, entitled CIRCUITS AND METHODS FOR 2G AMPLIFICATION USING 3G/4G LINEAR PATH COMBINATION, and its corresponding U.S. Application entitled CIRCUITS AND METHODS FOR 2G AMPLIFICATION USING 3G/4G LINEAR PATH COMBINATION, each of which is expressly incorporated by reference in its entirely, and which is to be considered part of the specification of the present application. As further shown in Figure 12, such a feature can eliminate the 2G HB PA from the 2G PA block 120.

In some embodiments, the input configuration that facilitates the foregoing functionality can be part of a routing circuit 100 implemented in the 3G/4G PA block 110. As shown in the example of Figure 12, such a routing circuit can also include a switch S3 that allows routing of 2G/3G4GMB signals to the 3G/4G MB PA (of the 3G/4G PA block 110), or to the 2G HB PA (of the 2G PA block 120) through an inter-block connection 115.

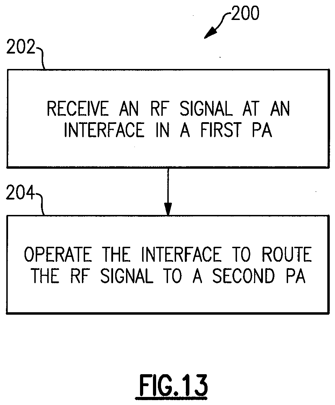

Figure 13 shows a process 200 that can be implemented to operate a PA system. In block 202, an RF signal can be received at an interface in a first PA. In block 204, the interface can be operated to route the RF signal to a second PA.

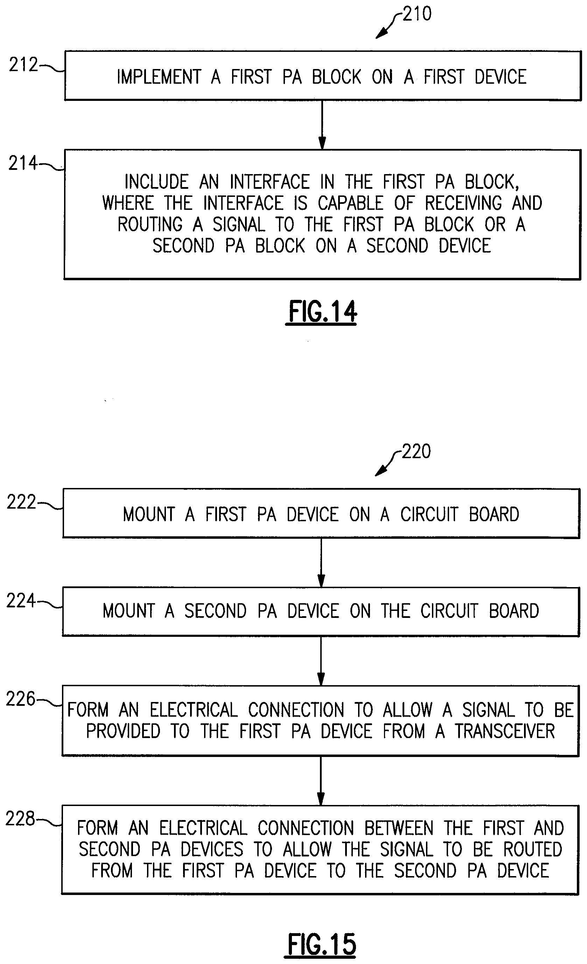

Figure 14 shows a process 210 that can be implemented to fabricate a device having a PA system. In block 212, a first PA block can be implemented on a first device. In block 214, an interface such as a routing circuit can be included in the first PA block. Such an interface can be configured to be capable of receiving and routing an RF signal to the first PA block or a second PA block on a second device.

Figure 15 shows a process 220 that can be utilized to implement a chipset in a wireless device such as a cellular phone. In block 222, a first PA device can be mounted on a circuit board. In block 224, a second PA device can be mounted on the circuit board. In block 226, an electrical connection can be formed to allow a signal to be provided to the first PA device from a transceiver. In block 228, an electrical connection can be made between the first and second PA devices to allow the signal to be routed from the first PA device to the second PA device.

In some implementations, a device and/or a circuit having one or more features described herein can be included in an RF device such as a wireless device. Such a device and/or a circuit can be implemented directly in the wireless device, in a modular form as described herein, or in some combination thereof. In some embodiments, such a wireless device can include, for example, a cellular phone, a smart-phone, a hand-held wireless device with or without phone functionality, a wireless tablet, etc.

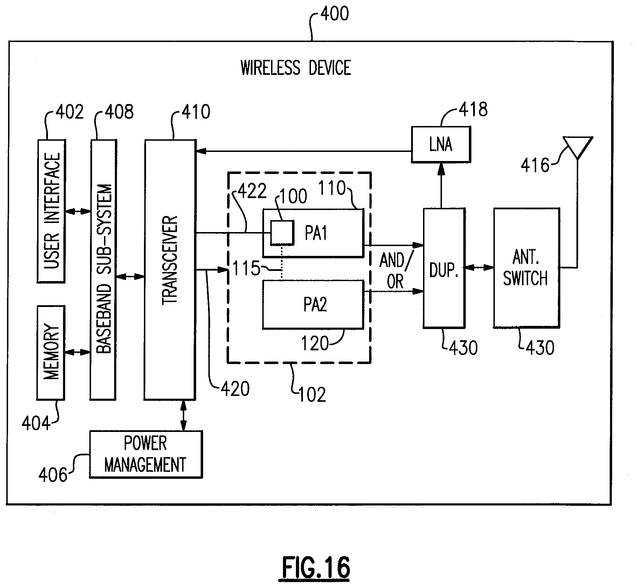

Figure 16 depicts an example wireless device 400 having one or more advantageous features described herein. In the context of a PA system having one or more features as described herein, such a PA system can be generally depicted by a dashed box 102. As described herein, such a PA system can include first and second PA blocks 110, 120, and at least one of such PA blocks can include an interface 100 (e.g., a routing circuit). Such an interface can receive one or more RF signals from a transceiver 410, and be routed as described herein. Other RF signals 420 can also be provided to the RF system 102 from the transceiver 410. In some embodiments (e.g., if the transceiver 410 provides frequency-separated signals), the PA system 102 can include one or more electrical connections 115 between the first and second PA blocks 110, 120.

As further shown in Figure 16, amplified signals from either or both of the PA blocks 110, 120 can be provided to an assembly of duplexers 430. Such amplified signals can then be routed to an antenna 416 through an antenna switch 432 for transmission.

In the example wireless device 400, RF signals received through the antenna 416 can be routed to one or more low-noise amplifiers (LNAs) 418 through the antenna switch 432 and the duplexers 430. The output(s) from the LNA(s) 418 can be routed to the transceiver 410 for further processing.

The transceiver 410 is shown to interact with a baseband sub-system 408 that is configured to provide conversion between data and/or voice signals suitable for a user and RF signals suitable for the transceiver 410. The transceiver 410 is also shown to be connected to a power management component 406 that is configured to manage power for the operation of the wireless device. Such power management can also control operations of the baseband sub-system 408 and the PA system 102.

The baseband sub-system 408 is shown to be connected to a user interface 402 to facilitate various input and output of voice and/or data provided to and received from the user. The baseband sub-system 408 can also be connected to a memory 404 that is configured to store data and/or instructions to facilitate the operation of the wireless device, and/or to provide storage of information for the user.

A number of other wireless device configurations can utilize one or more features described herein. For example, a wireless device does not need to be a multi-band device. In another example, a wireless device can include additional antennas such as diversity antenna, and additional connectivity features such as Wi-Fi, Bluetooth, and GPS.

Unless the context clearly requires otherwise, throughout the description and the claims, the words "comprise," "comprising," and the like are to be construed in an inclusive sense, as opposed to an exclusive or exhaustive sense; that is to say, in the sense of "including, but not limited to." The word "coupled", as generally used herein, refers to two or more elements that may be either directly connected, or connected by way of one or more intermediate elements. Additionally, the words "herein," "above," "below," and words of similar import, when used in this application, shall refer to this application as a whole and not to any particular portions of this application. Where the context permits, words in the above Description using the singular or plural number may also include the plural or singular number respectively. The word "or" in reference to a list of two or more items, that word covers all of the following interpretations of the word: any of the items in the list, all of the items in the list, and any combination of the items in the list.

The above detailed description of embodiments of the invention is not intended to be exhaustive or to limit the invention to the precise form disclosed above. While specific embodiments of, and examples for, the invention are described above for illustrative purposes, various equivalent modifications are possible within the scope of the invention defined by the appended claims, as those skilled in the relevant art will recognize. For example, while processes or blocks are presented in a given order, alternative embodiments may perform routines having steps, or employ systems having blocks, in a different order, and some processes or blocks may be deleted, moved, added, subdivided, combined, and/or modified. Each of these processes or blocks may be implemented in a variety of different ways. Also, while processes or blocks are at times shown as being performed in series, these processes or blocks may instead be performed in parallel, or may be performed at different times.

While some embodiments of the inventions have been described, these embodiments have been presented by way of example only. Indeed, the novel methods and systems described herein may be embodied in a variety of other forms; furthermore, various omissions, substitutions and changes in the form of the methods and systems described herein may be made within the scope of the invention which is defined by the appended claims.

## Claims

1. A power amplifier, PA, system (152; 156; 162) comprising:
a first PA module (110) including a plurality of first PAs (112) configured to operate in a 2G or 3G mode, each of the plurality of first PAs (112) being configured to amplify a radio-frequency, RF, signal for transmission;
a second PA module (120) separate from the first PA module (110) including a plurality of second PAs (122) configured to operate selectively in both, a 3G or 2G mode, each of the plurality of second PAs (122) being configured to amplify an RF signal for transmission;
an interface (100) implemented as routing circuit (106) within the first PA module (110), the interface (100) configured to be capable of routing a frequency-separated RF signal received from a transceiver (104) at a first input port (113a) of the first PA module (110) to the one of the plurality of first PAs (112), the interface (100) further configured to be capable of routing the frequency-separated RF signal to one of the plurality of second PAs (122) and the interface (100) including at least one single-pole double-throw switch (S1; S2; S3), the at least one single-pole double-throw switch (S1; S2; S3) having its pole connected to the first input port (113a) of the first PA module (110) and its first throw selectively connected to the plurality of first PAs (112); and
a signal path (144) implemented between the interface (100) within the first PA module (110) and the second PA module (120) for routing a frequency-separated RF signal received from the transceiver (104) at a first input port (113a) of the first PA module (110) through the routing circuit (106) within the first PA module (110) to the second PA module (120), the second throw of the the at least one single-pole double-throw switch (S1; S2; S3) connected to an interface port (114a; 114b) of the first PA module (110) to selectively allow the routing of the RF signal through the signal path (144) to the plurality of second PAs (122).

2. The PA system of claim 1 wherein the first PA module (110) includes dual-band PAs.

3. The PA system of claim 2 wherein the first PA module (110) includes a 2G transmit front-end module.

4. The PA system of claim 1 wherein second PA module (120) includes multi-band PAs.

5. The PA system of claim 4 wherein the second PA module (120) includes a 3G multi-band module.

6. The PA system of claim 1 wherein the first PA module (110) and the second PA module (120) are configured to process 2G and 3G signals independent from each other.

7. The PA system of claim 6 wherein the first PA module (110) is configured for the 2G mode, and the second PA module (120) is configured for the 3G mode.

8. The PA system of claim 6 wherein the first PA module (110) is configured for the 3G mode, and the second PA module (120) is configured for the 2G mode.

9. The PA system of claim 1 wherein the first PA module (110) includes a plurality of amplification paths including a 2G low band, LB, and a 2G high band, HB.

10. The PA system of claim 1 wherein the second PA module (120) includes a plurality of amplification paths including a 2G low band, LB, and a 2G high band, HB.

11. The PA system of claim 1 wherein the second PA module (120) includes a plurality of amplification paths including a 3G low band, LB, and a 3G mid band, MB.

12. A wireless device (400) comprising:
a transceiver (410) configured to generate a radio-frequency, RF, signal;
the PA system (152; 156) of any of claims 1-11; and
an antenna (416) in communication with the PA system (152; 156), the antenna (416) configured to transmit the amplified RF signal.

## Patentansprüche

1. Leistungsverstärker-, PA- (*Power Amplifier*)-*System* (152; 156; 162), umfassend:
ein erstes PA-Modul (110), das mehrere erste PA (112) umfasst, die dafür eingerichtet sind, in einem 2G- oder 3G-Modus zu arbeiten, wobei jeder der mehrere ersten PAs (112) dafür eingerichtet ist, ein Hochfrequenz (HF)-Signal zur Übertragung zu verstärken;
ein zweites PA-Modul (110), das von dem ersten PA-Modul (120) getrennt ist und mehrere zweite PA-Module (122) umfasst, die dafür eingerichtet sind, selektiv in einem 3G-Modus oder einem 2G-Modus zu arbeiten, wobei jedes der mehreren zweiten PA-Module (122) dafür eingerichtet ist, ein HF-Signal zur Übertragung zu verstärken;
eine Schnittstelle (100), die als Routungsschaltkreis (106) innerhalb des ersten PA-Moduls (110) implementiert ist, wobei die Schnittstelle (100) dafür eingerichtet ist, ein frequenzgetrenntes HF-Signal, das von einem Transceiver (104) an einem ersten Eingangsanschluss (113a) des ersten PA-Moduls (110) empfangen wird, zu einem der mehreren ersten PAs (112) routen zu können, wobei die Schnittstelle (100) des Weiteren dafür eingerichtet ist, das frequenzgetrennte HF-Signal zu einem der mehreren zweiten PAs (122) routen zu können, und wobei die Schnittstelle (100) mindestens einen einpoligen Umschalter (S1; S2; S3) umfasst, wobei der Pol des mindestens einen einpoligen Umschalters (S1; S2; S3) mit dem ersten Eingangsanschluss (113a) des ersten PA-Moduls (110) verbunden ist und der erste Schaltkontakt des mindestens einen einpoligen Umschalters (S1; S2; S3) selektiv mit den mehreren ersten PAs (112) verbunden wird; und
einen Signalpfad (144), der zwischen der Schnittstelle (100) innerhalb des ersten PA-Moduls (110) und dem zweiten PA-Modul (120) implementiert ist, um ein von dem Transceiver (104) an einem ersten Eingangsanschluss (113a) des ersten PA-Moduls (110) empfangenes frequenzgetrenntes HF-Signal durch die Routungsschaltkreis (106) innerhalb des ersten PA-Moduls (110) zu dem zweiten PA-Modul (120) zu leiten, wobei der zweite Schaltkontakt des mindestens einen einpoligen Umschalters (S1; S2; S3), der mit einem Schnittstellenport (114a; 114b) des ersten PA-Moduls (110) verbunden ist, um selektiv das Routen des HF-Signals durch den Signalpfad (144) zu den mehreren zweiten PA-Modulen (122) zu ermöglichen.

2. PA-System nach Anspruch 1, wobei das erste PA-Modul (110) Dualband-PAs umfasst.

3. PA-System nach Anspruch 2, wobei das erste PA-Modul (110) ein 2G-Sende-Frontend-Modul umfasst.

4. PA-System nach Anspruch 1, wobei das erste PA-Modul (120) Dualband-PAs enth umfasst umfasst.

5. PA-System nach Anspruch 1, wobei das zweite PA-Modul (120) Mehrband-PAs umfasst.

6. PA-System nach Anspruch 1, wobei das erste PA-Modul (110) und das zweite PA-Modul (120) dafür eingerichtet sind, unabhängig voneinander 2G- und 3G-Signale zu verarbeiten.

7. PA-System nach Anspruch 6, wobei das erste PA-Modul (110) für den 2G-Modus eingerichtet ist und das zweite PA-Modul (120) für den 3G-Modus eingerichtet ist.

8. PA-System nach Anspruch 6, wobei das erste PA-Modul (110) für den 3G-Modus eingerichtet ist und das zweite PA-Modul (120) für den 2G-Modus eingerichtet ist.

9. PA-System nach Anspruch 1, wobei das erste PA-Modul (110) mehrere Verstärkungspfade, einschließlich eines 2G Low Band (LB) und eines 2G High Band (HB), umfasst.

10. PA-System nach Anspruch 1, wobei das zweite PA-Modul (120) mehrere Verstärkungspfade, einschließlich eines 2G Low Band (LB) und eines 2G High Band (HB), umfasst.

11. PA-System nach Anspruch 1, wobei das zweite PA-Modul (120) mehrere Verstärkungspfade, einschließlich eines 3G Low Band (LB) und eines 3G Mid Band (MB), umfasst.

12. Drahtlosvorrichtung (400), umfassend:
einen Transceiver (410), der dafür eingerichtet ist, ein Hochfrequenz (HF)-Signal zu erzeugen;
das PA-System (152; 156) nach einem der Ansprüche 1-11; und
eine Antenne (416) in Kommunikation mit dem PA-System (152; 156), wobei die Antenne (416) dafür eingerichtet ist, das verstärkte HF-Signal zu senden.

## Revendications

1. Amplificateur de puissance, PA (*power amplifier*) (152 ; 156 ; 162) comprenant :
un module de premiers amplificateurs PA (110) comportant une pluralité de premiers amplificateurs PA (112) conçus pour fonctionner dans un mode 2G ou 3G, chaque amplificateur de la pluralité de premiers amplificateurs PA (112) étant conçu pour amplifier un signal radioélectrique, RF, à des fins de transmission ;
un module de seconds amplificateurs PA (120) séparé du module de premiers amplificateurs PA (110), comportant une pluralité de seconds amplificateurs PA (122) conçus pour fonctionner de manière sélective tant dans un mode 3G que dans un mode 2G, chaque amplificateur de la pluralité de seconds amplificateurs PA (122) étant conçu pour amplifier un signal radioélectrique à des fins de transmission ;
une interface (100) mise en œuvre sous la forme d'un circuit d'acheminement (106) au sein du module de premiers amplificateurs PA (110), l'interface (100) étant conçue pour être apte à acheminer un signal radioélectrique séparé en fréquence, reçu en provenance d'un émetteur-récepteur (104) à un premier port d'entrée (113a) du module de premiers amplificateurs PA (110) vers l'amplificateur de la pluralité de premiers amplificateurs PA (112), l'interface (100) étant conçue en outre pour être apte à acheminer le signal radioélectrique séparé en fréquence vers un amplificateur de la pluralité de seconds amplificateurs PA (122) et l'interface (100) comportant au moins un commutateur unipolaire à deux directions (S1 ; S2 ; S3), l'au moins un commutateur unipolaire à deux directions (S1 ; S2 ; S3) ayant son pôle connecté au premier port d'entrée (113a) du module de premiers amplificateurs PA (110) et sa première direction connectée de manière sélective à la pluralité de premiers amplificateurs PA (112) ; et
un trajet de signal (144) mis en œuvre entre l'interface (100) au sein du module de premiers amplificateurs PA (110) et le module de seconds amplificateurs PA (120) pour acheminer un signal radioélectrique séparé en fréquence, reçu en provenance de l'émetteur-récepteur (104) à un premier port d'entrée (113a) du module de premiers amplificateurs PA (110) par le biais du circuit d'acheminement (106) au sein du module de premiers amplificateurs PA (110) vers le module de seconds amplificateurs PA (120), la seconde direction de l'au moins un commutateur unipolaire à deux directions (S1 ; S2 ; S3) étant connectée à un port d'interface (114a ; 114b) du module de premiers amplificateurs PA (110) pour permettre l'acheminement sélectif du signal radioélectrique par le biais du trajet de signal (144) vers la pluralité de seconds amplificateurs PA (122).

2. Système d'amplificateurs PA selon la revendication 1, dans lequel le module de premiers amplificateurs PA (110) comporte des amplificateurs PA doubles bandes.

3. Système d'amplificateurs PA selon la revendication 2, dans lequel le module de premiers amplificateurs PA (110) inclut un module frontal de transmission en 2G.

4. Système d'amplificateurs PA selon la revendication 1, dans lequel le module de seconds amplificateurs PA (120) comporte des amplificateurs PA multibandes.

5. Système d'amplificateurs PA selon la revendication 4, dans lequel le module de seconds amplificateurs PA (120) inclut un module multibande 3G.

6. Système d'amplificateurs PA selon la revendication 1, dans lequel le module de premiers amplificateurs PA (110) et le module de seconds amplificateurs PA (120) sont conçus pour traiter des signaux 2G et 3G indépendamment l'un de l'autre.

7. Système d'amplificateurs PA selon la revendication 6, dans lequel le module de premiers amplificateurs PA (110) est conçu pour le mode 2G, et le module de seconds amplificateurs PA (120) est conçu pour le mode 3G.

8. Système d'amplificateurs PA selon la revendication 6, dans lequel le module de premiers amplificateurs PA (110) est conçu pour le mode 3G, et le module de seconds amplificateurs PA (120) est conçu pour le mode 2G.

9. Système d'amplificateurs PA selon la revendication 1, dans lequel le module de premiers amplificateurs PA (110) comporte une pluralité de trajets d'amplification incluant une bande de basses fréquences LB (*low band*) 2G et une bande de hautes fréquences HB (*high band*) 2G.

10. Système d'amplificateurs PA selon la revendication 1, dans lequel le module de seconds amplificateurs PA (120) comporte une pluralité de trajets d'amplification incluant une bande de basses fréquences LB 2G et une bande de hautes fréquences HB 2G.

11. Système d'amplificateurs PA selon la revendication 1, dans lequel le module de seconds amplificateurs PA (120) comporte une pluralité de trajets d'amplification incluant une bande de basses fréquences LB 3G et une bande de moyennes fréquences MB (*mid band*) 3G.

12. Dispositif sans fil (400) comprenant :
un émetteur-récepteur (410) conçu pour produire un signal radioélectrique, RF ;
le système d'amplificateurs PA (152 ; 156) selon l'une quelconque des revendications 1 à 11 ; et
une antenne (416) en communication avec le système d'amplificateurs PA (152 ; 156), l'antenne (416) étant conçue pour transmettre le signal radioélectrique amplifié.
